(19) Europäisches Patentamt
European Patent Office
Office européen des brevets

(11) EP 0 831 373 B1

(12) EUROPEAN PATENT SPECIFICATION

(45) Date of publication and mention of the grant of the patent:
**21.01.2004 Bulletin 2004/04**

(51) Int Cl.[7]: **G03F 7/027**, G03C 9/08

(21) Application number: **97202886.4**

(22) Date of filing: **19.09.1997**

(54) **Photo-curable resin compositions and process for preparing a resin-based mold**

Photohärtbare Harzzusammensetzungen und Verfahren zur Herstellung von einer Form auf Harzbasis

Compositions photosensibles à base de résine et procédé de fabrication d'un moule à base de résine

(84) Designated Contracting States:
**CH DE FR GB LI**

(30) Priority: **20.09.1996 JP 25058496**

(43) Date of publication of application:
**25.03.1998 Bulletin 1998/13**

(73) Proprietors:
- **DSM IP Assets B.V.**
  **6411 TE Heerlen (NL)**
- **JAPAN SYNTHETIC RUBBER CO., LTD.**
  **Tokyo 104 (JP)**
- **Japan Fine Coatings Co., Ltd.**
  **Tokyo 104-8410 (JP)**

(72) Inventors:
- **Watanabe, Tsuyoshi**
  **Tsukuba, Ibaraki 305 (JP)**
- **Haruta, Yuichi**
  **Tsuchiura, Ibaraki 300 (JP)**
- **Takase, Hideaki**
  **Tsukuba, Ibaraki 305 (JP)**
- **Ukachi, Takashi**
  **Ushiku, Ibaraki 300-12 (JP)**

(74) Representative:
**den Hartog, Jeroen Hendrikus Joseph et al**
**DSM Patents & Trademarks**
**Office Geleen**
**P.O. Box 9**
**6160 MA Geleen (NL)**

(56) References cited:
**EP-A- 0 781 639** **JP-A- 8 020 620**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 831 373 B1

**Description**

BACKGROUND OF THE INVENTION

Field of the Invention

The present invention relates to a photo-curable resin composition and a process for preparing a resin mold by photo-fabricating using the photo-curable resin composition.

Description of the Background Art

In recent years, photo-fabricating processes for forming three-dimensional objects consisting of integrally laminated cured resin layers prepared by repeating a step of forming a cured resin layer by selectively irradiating a liquid photo-curable material with light have been proposed (see Japanese Patent Application Laid-open No. 247515/1985, USP No. 4,575,330 (Japanese Patent Application Laid-open No. 35966/1987), Japanese Patent Application Laid-open No. 101408/1987, Japanese Patent Application Laid-open No. 24119/1993). These photo-fabricating processes are attractive due to their capability of easily forming the target three-dimensional object in a short period of time even when the shape of the object is complicated.

A typical example of such an photo-fabricating process comprises forming a thin layer of a liquid photo-curable resin composition, selectively irradiating this thin layer with light, using, for example, an ultraviolet radiation laser to obtain a cured resin layer, feeding the photo-curable resin composition to form another thin layer of the composition over this cured resin layer, and selectively irradiating this thin layer with light to form a new cured resin layer which is integrally laminated over the previously formed cured resin layer. This combination of steps is repeated a number of times, with or without changing the pattern in which the light is irradiated to form a three-dimensional object consisting of integrally laminated multiple cured resin layers.

The required characteristics of the photo-curable resin composition used for these photo-fabricating processes include a low viscosity, the capability of being rapidly cured by irradiation of light, non-swelling of the cured products when contacted by a photo-curable resin composition and minimal deformation due to shrinkage during curing with light or in a post-curing step. In particular in the production of warped parts, indented parts, or stretched parts (overhanging parts), high dimensional accuracy of the cured product is difficult to achieve. Furthermore, the resin should be capable of molding even when the shape of the object is complicated.

Three-dimensional objects prepared by photo-fabricating methods have conventionally been used for design models, models for medical services, and master models for resin molds. In recent years, attempts have been made to produce mount parts such as a connector, a plug, or a fan and to incorporate these parts for test purposes in products such as a heater, a motor, or an engine, wherein the mount parts are directly manufactured by photo-fabricating methods. In addition to high dimensional accuracy, these parts are required to have mechanical strength and heat resistance sufficient to withstand conditions of use. However, the conventional photo-fabricating method using a photo-curable resin composition cannot produce cured products with sufficient mechanical strength and heat resistance. It has therefore been difficult to manufacture three-dimensional objects for mounting parts having good mechanical strength and heat resistance which can withstand actual conditions of use.

Furthermore, there has been an attempt to manufacture a mold by a photo-fabricating method, for use in various molding methods such as injection molding, press molding, vacuum molding, high-pressure molding, foaming molding, or pulp molding.

However, no conventional photo-fabricating method using known photo-curable resin compositions can produce photo-fabricating objects possessing sufficient mechanical strength, pressure resistance, and heat resistance as demanded of such a resin-based mold. Specifically, no conventional resin compositions have been known which withstand the conditions of high temperature and high pressure in the injection molding method using engineering plastics under these conditions. It is therefore difficult to manufacture a resin-based mold having excellent repetition durability by a photo-fabricating method.

The present invention has been achieved in view of this situation and has an object of providing a photo-curable resin composition which can produce cured products having excellent mechanical strength and heat resistance and which is suitable as photo-curable material used in the photo-fabricating method. Another object of the present invention is to provide a process for easily manufacturing a resin-based mold which has high dimensional accuracy and exhibits superior repetition durability.

SUMMARY OF THE INVENTION

The above objects can be attained in the present invention by a photo-curable resin composition comprising,

(A) a compound having a cyclohexene oxide structure;
(B) a cationic photo-initiator;
(C) an ethylenically unsaturated polymer;
(D) a radical photo-initiator; and
(E) spherical silica particles;

and wherein the heat distortion temperature of the cured resin produced from the photo-curable resin composition is 100°C or higher.

The above objects can also be attained in the present invention by a process for preparing a resin-based mold comprising a plurality of integrally laminated layers of cured resin by repeating the step of forming a cured resin layer by selectively irradiating a photo-curable material with light, wherein the photo-curable material is the above-mentioned photo-curable resin composition.

BRIEF DESCRIPTION OF THE DRAWINGS

Figure 1 is a diagram showing the configuration of the resin-based mold prepared in the Example.
Figure 2 is a side elevation of the resin-based mold shown in Figure 1.

DETAILED DESCRIPTION OF THE INVENTION AND PREFERRED EMBODIMENTS

The present invention will now be explained in detail.

The photo-curable resin composition of the present invention comprises as essential components the component (A), a compound having a cyclohexene oxide structure; the component (B), a cationic photo-initiator; the component (C), an ethylenicallyally unsaturated monomer; the component (D), a radical photo-initiator; and the component (E), spherical silica particles.

Component (A)

The compounds having a cyclohexene oxide structure, which are the component (A), are cationic polymerizable organic compounds which are polymerized and/or cross-linked in the presence of a cationic photo-initiator by irradiating with light.

The epoxy compound (A) generally has a molecular weight of about 1000 or less, preferably it has a molecular weight of about 400 or lower and of about 100 or higher. Particularly preferred are epoxy compounds having on average about two epoxy groups.

Examples of these compounds having a cyclohexene oxide structure include 3,4-epoxycyclohexylmethyl-3'4'-epoxycyclohexane carboxylate, 2-(3,4-epoxycyclohexyl-5,5-spiro-3,4-epoxy)cyclohexane-meth-dioxane, bis (3,4-epoxycyclohexylmethyl) adipate, vinylcyclohexene oxide, 4-vinylepoxycyclohexane, bis(3,4-epoxy-6-methylcyclohexylmethyl) adipate, 3,4-epoxy-6-methylcyclohexyl-3',4'-epoxy-6'-methylcyclohexane carboxylate, methylene bis (3,4-epoxycyclohexane), dicyclopentadiene diepoxide, di(3,4-epoxycyclohexylmethyl ether of ethylene glycol, ethylene bis(3,4-epoxycyclohexane carboxylate, lactone modified 3,4-epoxycyclohexylmethyl-3'4'-epoxycyclohexane carboxylate, epoxydated tetrahydrobenzyl alcohol, lactone modified epoxydated tetrahydrobenzyl alcohol, and cyclohexene oxide. These compounds may be used as the component (A) either individually or in combinations of two or more.

Among these compounds, preferred compounds having a cyclohexene oxide structure as the component (A) include epoxy compounds having two or more aliphatic epoxy groups, such as 3,4-epoxycyclohexylmethyl-3'4'-epoxycyclohexane carboxylate, bis(3,4-epoxycyclohexylmethyl) adipate, and the like. When such an epoxy compound is formulated in the amount of 50-100% by weight in the component (A) the rate of cationic polymerization reaction is accelerated, leading to reduction of fabrication time, and the deformation rate with time of the three-dimensional object from the photo-curable composition of the present invention is restrained because the rate of curing shrinkage becomes small.

The following compounds are given as specific examples of commercially available products of the compounds having a cyclohexene oxide structure: UVR-6100, UVR-6105, UVR-6110, UVR UVR-6128, UVR-6200 (manufactured by Union Carbide Corporation), Celoxide 2021, Celoxide 2021P, Celoxide 2081, Celoxide 2083, Celoxide 2085, Celoxide 2000, Celoxide 3000, Cyclomer A200, Cyclomer M100, Cyclomer M101, Epolead GT-301, Epolead GT-302, Epolead 401, Epolead 403, ETHB, Epolead HD300 (manufactured by Daicel Chemical Industries, Ltd.), KRM-2110, KRM-2199 (manufactured by Asahi Denka Kogyo Co., Ltd.).

The proportion of the component (A) in the photo-curable resin composition of the present invention is 5-60%

by weight, preferably 10-50% by weight, and more preferably 15-40% by weight. If the proportion of the component (A) is too low, the photo-curability of the prepared resin composition is reduced, leading to a decrease in the fabrication effect. On the other hand, if the proportion of the component (A) is too high, the toughness of the three-dimensional object prepared from the resin composition is decreased and the durability required for the resulting mold tends to be reduced.

Component (B)

The cationic photo-initiator used as the component (B) is a compound capable of liberating a substance which initiates cationic polymerization of the component (A) by receiving radiation such as light.

Preferred examples of the cationic photo-initiator include onium salts illustrated by the following formula (1), which are compounds which release Lewis acid on receiving light:

$$[R^1{}_aR^2{}_bR^3{}_cR^4{}_dZ]^{+m}[MX_n]^{-m} \quad (1)$$

wherein the cation is onium; Z represents S, Se, Te, P, As, Sb, Bi, O, I, Br, Cl, or N≡N; $R^1$, $R^2$, $R^3$, and $R^4$ represent individually the same or different organic groups; a, b, c, and d represent individually integers from 0 to 3, and the summarized number of a, b, c, and d (=a+b+c+d) is equal to the valence number of Z. M represents a metal or metalloid which constitutes a center atom of a halide complex. Typical examples of M are B, P, As, Sb, Fe, Sn, Bi, Al, Ca, In, Ti, Zn, Sc, V, Cr, Mn, and Co. X represents a halogen atom. m is a substantial electric charge and n is the number of halogen atoms in the halide complex ion.

Given as specific examples of the negative ion ($MX_n$) in the above formula (1) are teteraf luoroborate ($BF_4^-$), hexafluorophosphate ($PF_6^-$), hexafluoroantimonate ($SbF_6^-$), hexafluoroarsenate ($AsF_6^-$), and hexachloroantimonate ($SbCl_6^-$).

Also, onium salts represented by the general formula $[MX_n(OH)^-]$ can be used as the cationic polymerizable initiator. Further, onium salts including a negative ion, for example, perchloric acid ion ($ClO_4^-$), trifluoromethane sulfonate ion ($CF_3SO_3^-$), fluorosulfonate ion ($FSO_3^-$), toluene sulfonate ion, trinitrobenzene sulfonate negative ion, and trinitrotoluene sulfonate negative ion are suitable.

These cationic photo-initiators may be used as the component (B) individually or in combinations of two or more.

Among these onium salts, especially effective onium salts are aromatic onium salts, in which the following compounds are preferred: aromatic halonium salts described, for example, in Japanese Patent Applications Laid-open No. 151996/1975 and No. 158680/1975; VIA group aromatic onium salts described, for example, in Japanese Patent Applications Laid-open No. 151997/1975, No. 30899/1977, No. 55420/1981, and No. 125105/1980; VA group aromatic onium salts described, for example, in Japanese Patent Application Laid-open No. 158698/1975; oxosulfoxonium salts described, for example, in Japanese Patent Applications Laid-open No. 8428/1981, No. 149402/1981, and No. 192429/1982; aromatic diazonium salts described, for example, in Japanese Patent Application Laid-open No. 17040/1974; and thiobililium salts described in the specification of USP No. 4,139,655. Iron/allene complex and aluminum complex/photo-decomposed silica compound initiator are also given as examples of the onium salts.

Preferred examples of commercially available products of the cationic photo-initiator which can be used as the component (B) include UVI-6950, UVI-6970, UVI-6974, UVI-6990 (manufactured by Union Carbide Corporation), Adekaoptomer SP-150, SP-151, SP-170, SP-171 (manufactured by Asahi Denka Kogyo Co., Ltd.), Irgacure 261 (manufactured by Ciba Geigy), CI-2481, CI-2624, CI-2639, CI-2064 (manufactured by Nippon Soda Co., Ltd.), CD-1010, CD-1011, CD-1012 (manufactured by Sartomer Co., Ltd.), DTS-102, DTS-103, NAT-103, NDS-103, TPS-103, MDS-103, MPI-103, BBI-103 (manufactured by Midori Chemical Co., Ltd.). Among these, UVI-6970, UVI-6974, Adekaoptomer SP-170, SP-171, and CD-1012, MPI-103 are particularly preferred to develop high curing sensitivity of the resin composition which contains these compounds.

The proportion of the component (B) in the photo-curable resin composition is 0.1-10% by weight, preferably 0.2-5% by weight, and more preferably 0.3-3% by weight. If the proportion of the component (B) is too low, the photo-curing characteristic of the resin composition obtained is insufficient. Hence, the produced three-dimensional object may have insufficient mechanical strength. Alternatively, if the proportion of the component (B) is too high, an appropriate light transmission capability (curing depth) cannot be obtained when the resulting resin composition is used in the photo-fabricating process. Mechanical strength such as the toughness of the three-dimensional object prepared from this resin composition tends to be reduced.

Component (C)

The ethylenically unsaturated monomer used as the component (C) is a compound having ethylenically unsaturated groups (C=C) in the molecule. Typical examples of the component (C) include monofunctional monomers having one ethylenically unsaturated bond in one molecule, and polyfunctional monomers having two or more ethylenically unsaturated bonds in one molecule.

The unsaturated monomer generally has a molecular weight of about 80 or more, up to about 2000 or less. Preferably, the molecular weight is 1000 or less.

Preferred examples of the monofunctional monomer used as the component (C) include acrylamide, (meth) acryloyl morpholine, 7-amino-3,7-dimethyloctyl (meth)acrylate, isobutoxymethyl (meth)acrylamide, isobornyloxyethyl (meth)acrylate, isobornyl (meth)acrylate, 2-ethylhexyl (meth)acrylate, ethyldiethylene glycol (meth)acrylate, t-octyl (meth)acrylamide, diacetone (meth)acrylamide, dimethylaminoethyl (meth)acrylate, diethylaminoethyl (meth)acrylate, lauryl (meth)acrylate, dicyclopentadiene (meth)acrylate, dicyclopentenyloxyethyl (meth)acrylate, dicyclopentenyl (meth)acrylate, N,N-dimethyl (meth)acrylamide tetrachlorophenyl (meth)acrylate, 2-tetrachlorophenoxyethyl (meth) acrylate, tetrahydrofurfuryl (meth)acrylate, tetrabromophenyl (meth)acrylate, 2-tetrabromophenoxyethyl (meth)acrylate, 2-trichlorophenoxyethyl (meth)acrylate, tribromophenyl (meth)acrylate, 2-tribromophenoxyethyl (meth)acrylate, 2-hydroxyethyl (meth)acrylate, 2-hydroxypropyl (meth)acrylate, vinyl caprolactam, N-vinyl pyrrolidone, phenoxyethyl (meth)acrylate, butoxyethyl (meth)acrylate, pentachlorophenyl (meth)acrylate, pentabromophenyl (meth)acrylate, polyethylene glycol mono(meth)acrylate, polypropylene glycol mono(meth)acrylate, bornyl (meth)acrylate, methyltriethylene diglycol (meth)acrylate, and, the compounds shown in the following general formulas (2) to (4).

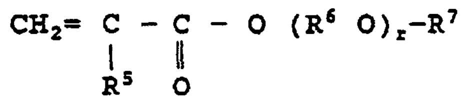
(2)

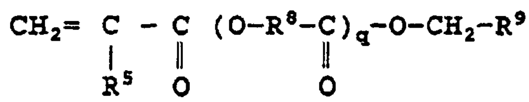
(3)

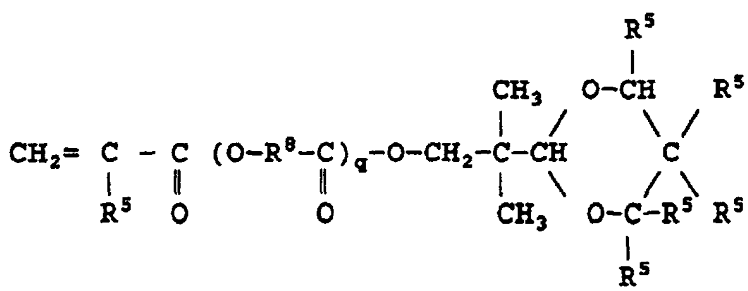
(4)

wherein $R^5$ represents a hydrogen atom or a methyl group, $R^6$ represents an alkylene group containing 2-6, preferably 2-4 carbon atoms, $R^7$ represents an aromatic group, optionally substituted with an alkyl group containing 1-12, preferably 1-9 carbon atoms, $R^8$ represents an alkylene group containing 2-8, preferably 2-5 carbon atoms, r denotes an integer from 0-12, preferably from 1-8, and q denotes an integer from 1-8, preferably from 1-4; $R^9$ is a tetrahydrofuryl group.

Among these monofunctional monomers, isobornyl (meth)acrylate, lauryl (meth)acrylate, and phenoxyethyl (meth)acrylate are particularly preferred.

Examples of commercially available products of the monofunctional monomers include Aronix M-101, M-102, M-111, M-113, M-117, M-152, TO-1210 (manufactured by Toagosei Co., Ltd.), KAYARAD TC-110S, R-564, R-128H (manufactured by Nippon Kayaku Co., Ltd.), Viscoat 192, Viscoat 220, Viscoat 2311HP, Viscoat 2000, Viscoat 2100, Viscoat 2150, Viscoat 8F, Viscoat 17F (manufactured by Osaka Organic Chemical Industry Co., Ltd.)

Preferred examples of the polyfunctional monomers used as the component (C) include di(meth)acrylate compounds such as ethylene glycol di(meth)acrylate, dicyclopentenyl di(meth)acrylate, triethylene glycol di(meth)acrylate, tetraethylene glycol di(meth)acrylate, tricyclodecanediyldimethylene di(meth)acrylate, tris(2-hydroxyethyl) isocyanurate di(meth)acrylate, tripropylene glycol di(meth)acrylate, neopentyl glycol di(meth)acrylate, both terminal (meth)acrylic acid adduct of bisphenol A diglycidyl ether, 1,4-butanediol di(meth)acrylate, 1,6-hexanediol di(meth)acrylate, polyester di(meth)acrylate, polyethylene glycol di(meth)acrylate, ethylene oxide (hereainafter called [EO]) modified bisphenol A di(meth)acrylate, propylene oxide (hereinafter called [PO]) modified bisphenol A di(meth)acrylate, EO modified hydrogenated bisphenol A di(meth)acrylate, PO modified hydrogenated bisphenol A di(meth)acrylate, and EO modified bisphenol F di(meth)acrylate; tri(meth)acrylate compounds such as tris(2-hydroxyethyl)isocyanurate tri(meth)acrylate, EO modified caprolactone modified tris(2-hydroxylethyl)isocyanurate tri(meth)acrylate, trimethylolpropane tri(meth)acrylate. EO modified trimethylolpropane tri(meth)acrylate, PO modified trimethylolpropane tri(meth) acrylate, and pentaerythritol tri(meth)acrylate; tetra(meth)acrylate compounds such as pentaerythritol tetra(meth)acrylate, dipentaerythritol tetra(meth)acrylate, and ditrimethylolpropane tetra(meth)acrylate; penta(meth)acrylate compounds such as dipentaerythritol penta(meth)acrylate and caprolactone modified dipentaerythritol penta(meth)acrylate; hexa(meth)acrylate compounds such as dipentaerythritol hexa(meth)acrylate and caprolactone modified dipentaerythritol hexa(meth)acrylate; and (meth)acrylate of phenol novolak polyglycidyl ether.

Commercially available products of these polyfunctional monomers include SA1002 (manufactured by Mitsubishi Chemical Corp.), Viscoat 195, Viscoat 230, Viscoat 260, Viscoat 215, Viscoat 310, Viscoat 214HP, Viscoat 295, Viscoat 300, Viscoat 360, Viscoat GPT, Viscoat 400, Viscoat 700, Viscoat 540, Viscoat 3000, Viscoat 3700 (manufactured by Osaka Organic Chemical Industry Co., Ltd.), Kayarad R-526, HDDA, NPGDA, TPGDA, MANDA, R-551, R-712, R-604, R-684, PET-30, GPO-303, TMPTA, THE-330, DPHA, DPHA-2H, DPHA-2C, DPHA-2I, D-310, D-330, DPCA-20, DPCA-30, DPCA-60, DPCA-120, DN-0075, DN-2475, T-1420, T-2020, T-2040, TPA-320, TPA-330, RP-1040, RP-2040, R-011, R-300, R-205 (manufactured by Nippon Kayaku Co., Ltd.), Aronix M-210, M-220, M-233, M-240, M-215, M-305, M-309, M-310, M-315, M-325, M-400, M-6200, M-6400 (manufactured by Toagosei Co., Ltd.), Light Acrylate BP-4EA, BP-4PA, BP-2EA, BP-2PA, DCP-A (manufactured by Kyoeisha Chemical Industry Co., Ltd.), New Frontier BPE-4, TEICA, BR-42M, GX-8345 (manufactured by Daiichi Kogyo Seiyaku Co., Ltd.), ASF-400 (manufactured by Nippon Steel Chemical Co., Ltd.), Lipoxi SP-1506, SP-1507, SP-1509, VR-77, SP-4010, SP-4060 (manufactured by Showa Highpolymer Co., Ltd.), and NK Ester A-BPE-4 (manufactured by Shin-Nakamura Chemical Industry Co., Ltd.).

The above-mentioned monofunctional monomers and polyfunctional monomers may be used as the component (C) either individually or in combinations of two or more. However, it is desirable that a polyfunctional monomer having three or more ethylenically unsaturated bonds in one molecule is used as all or part of the component (C). The proportion of the polyfunctional monomer having three or more functional groups is preferably more than 60% by weight and more preferably more than 80% by weight. A particularly preferable proportion of the polyfunctional monomer is substantially 100% by weight. If the proportion of the polyfunctional monomer having three or more functional groups is less than 60% by weight, the photo-curing characteristic of the resulting resin composition may become insufficient and the three-dimensional object fabricated tends to become deformed with time.

The polyfunctional monomer having three or more polyfunctional groups can be selected from the above-mentioned tri(meth)acrylate compounds, tetra(meth)acrylate compounds, penta(meth)acrylate compounds, and hexa (meth)acrylate compounds. Among these, trimethylol propane tri(meth)acrylate, EO modified trimethylolpropane tri (meth)acrylate, dipentaerythritol hexa(meth)acrylate, dipentaerythritol penta(meth)acrylate, and ditrimethylolpropane tetra(meth)acrylate are particularly preferred.

The proportion of the component (C) in the photo-curable resin composition of the present invention is generally 1-30% by weight, preferably 2-20% by weight, and more preferably 3-15% by weight. If the proportion of the component (C) is too low, the photo-curing characteristic of the resin composition may become insufficient. A three-dimensional object with sufficient mechanical strength cannot be molded from such a resin composition. On the other hand, if the proportion of the composition (C) is too high, the resulting resin composition shrinks easily during photo-curing and mechanical characteristics such as toughness of the three-dimensional object tend to be reduced.

Component (D)

The radical photo-initiator which is the component (D) of the resin composition of the present invention is a compound which decomposes and generates radicals by receiving radiation such as light and initiates a radical polymerization reaction of the component (C) by the action of the radicals.

Given as specific examples of the radical photo-initiators which can be used as the component (D) are acetophenone, acetophenone benzyl ketal, anthraquinone, 1-(4-isopropylphenyl)-2-hydroxy-2-methylpropan-1-one, carbazole, xanthone, 4-chlorobenzophenone, 4,4'-diaminobenzophenone, 1,1-dimethoxydeoxybenzoin, 3,3'-dimethyl-4-methoxybenzophenone, thioxanethone compounds, 2-methyl-1-[4-(methylthio) phenyl]-2-morpholino-propane-2-on, 2-benzyl-2-dimethylamino-1-(4-morpholinophenyl)-butane-1-one, triphenylamine, 2,4,6-trimethylbenzoyl diphenylphosphine oxide, bis(2,6-dimethoxybenzoyl)-2,4,4-tri-methylpentylphosphine oxide, benzyl dimethyl ketal, 1-hydroxycyclohexylphenyl ketone, 2-hydroxy-2-methyl-1-phenylpropan-1-one, fluorenone, fluorene, benzaldehyde, benzoin

ethyl ether, benzoin propyl ether, benzophenone, Michler's ketone, 3-methylacetophenone, 3,3',4,4'-tetra(t-butylperoxycarbonyl) benzophenone (BTTB), and combined compositions of BTTB and xanthene, thioxanthene, cumarin, ketocumarin or other coloring matter photosensitizer. These compounds may be used either individually or in combinations of two or more.

Among these, benzyl methyl ketal, 1-hydroxycyclohexyl phenyl ketone, 2,4,6-trimethylbenzoyl diphenylphosphine oxide, 2-benzyl-2-dimethylamino-1-(4-morpholinophenyl)-butan-1-one, and the like are particularly preferred.

The proportion of the component (D) in the photo-curable resin composition of the present invention is usually 0.01-8% by weight and preferably 0.1-5% by weight. If the proportion of the component (D) is too low, the rate (curing rate) of the radical polymerization is so reduced that fabrication time may be extended and the resolution may tend to be lower. On the other hand, if the proportion of the component (D) is too high, the excess polymerization initiator sometimes has an adverse effect on the curing characteristics of the resin composition and the specifications, heat resistance, and handling of the three-dimensional object obtained from the resin composition.

Component (E)

The present invention is characterized in that spherical silica particles (the component (E)) are used as a filler in the photo-curable resin composition of the present invention.

The spherical silica particles which are the component (E) improve the mechanical characteristics, heat resistance of the cured product and the durability of the resin-based mold formed from the cured product without damaging the photo-curing and fabricating characteristics of the resin composition containing these particles.

Namely, by using the silica particles, the cured products prepared from the resin composition containing such silica particles can exhibit excellent mechanical characteristics and heat resistance. Also, because the silica particles are spherical, the fluidity of the resin composition containing the particles is improved and an excellently smooth laminated surface can be formed in the photo-fabricating process. Also, there is no occurrence of the phenomenon in which uncured resin remains in the fabricated product, while this phenomenon is often observed when using undefined particles. A mold provided with either high dimensional accuracy or superior durability can be produced by fabricating the resin composition containing the spherical silica particles.

The spherical silica particles in the present invention are defined as particles having the average value of sphericity (hereinafter referred to as "average sphericity") of over 0.9. Here, sphericity, which is otherwise called degree of circularity, is defined by the following formula. When the shape of a projected image is exactly spherical, the sphericity is defined as 1.

$$\text{Sphericity} = \frac{\sqrt{4\pi S_p}}{C} = \frac{d_{pa}}{d_{pc}}$$

wherein $S_p$ is a projection area, c is the peripheral length of the projected image, $d_{pa}$ is the diameter of a circle having the same area as that of the projection area, and $d_{pc}$ is the diameter of a circle having the same peripheral length as the projected image of the particle.

This sphericity can be measured using an image analyzer which can analyze a microphotograph taken by a scanning electron microscope (SEM). The average sphericity can be measured by calculating the average sphericity of 100 particles arbitrarily selected from a multitude of particles appearing in the microphotograph.

The average sphericity of the silica particles which are the component (E) is preferably 0.92 or more, and more preferably 0.95 or more.

Any compound including silicon oxide containing as a major component and a less amount of impurity such as an alkaline metal can be used.

The average particle diameter of the spherical silica particles is preferably 1-50 µm, and more preferably 2-30 µm. If the average particle diameter is too small, the viscosity of the resulting resin composition is large and there are cases where the resulting cured product with a high dimensional accuracy can be produced only with difficulty. On the other hand, if the average particle diameter is too great, it is difficult to produce a cured product with a smooth surface from the resulting resin composition.

The spherical silica particles used as the component (E) may be surface-treated using silane coupling agents.

Specific examples of silane coupling agents include vinyltrichlorosilane, vinyltris (β-methoxy-ethoxy)silane, vinyltriethoxysilane, vinylmethoxysilane, γ-(methacryloxypropyl)trimethoxysilane, β-(3,4-epoxycyclohexyl)ethyltrimethoxysilane, γ-glysidoxypropyltrimethoxysilane, γ-glysidoxypropylmethyldiethoxysilane, N-β-(aminoethyl)γ-aminopropylmethyldimethoxysilane, γ-aminopropyltriethoxysilane, N-phenyl-γ-aminopropyltrimethoxysilane, γ-mercaptopropyltrimethoxysilane, and γ-chloropropyltrimethoxysilane.

Specific examples of commercially available silane coupling agent products include Sunsphere NP-100, NP-200 (manufactured by Doukai Chemical Industries Co., Ltd.), Silstar MK-08, MK-15 (Nippon Chemical Industries Co., Ltd.), and FB-48 (manufactured by Denki Kagaku Kogyo Co., Ltd.).

The proportion of the component (E) incorporated in the photo-curable resin composition is preferably 40-80% by weight and more preferably 45-75% by weight. If the proportion of the component (E) is too low, it is difficult to produce a cured product having high mechanical strength and excellent heat resistance and the durability of the resulting mold tends to be reduced. Alternatively, if the proportion of the component (E) is too high, the viscosity of the resin composition tends to be higher and a cured product having high dimensional accuracy can be obtained only with difficulty.

Optional components

In addition to the above-mentioned essential components (A) to (E), other components may be incorporated into the photo-curable resin composition of the present invention to the extent that the photocurability of this composition is not adversely affected. Such optional components include cationic polymerizable organic compounds other than above-mentioned component (A).

Typical examples of such cationic polymerizable organic compounds are epoxy compounds, oxetane compounds, oxalan compounds, cyclic acetal compounds, cyclic lactone compounds, thiirane compounds, thietane compounds, vinylether compounds, spiro-ortho ester compounds which are reaction products of an epoxy compound and lactone, ethylenically unsaturated compounds, cyclic ether compounds, cyclic thioether compounds, and vinyl compounds.

Compounds having a glycidyl ether structure, diglycidylesters of aliphatic long chain dibasic acid and glycidylesters of higher fatty acid are given as examples of epoxy compounds which can be used as the optional component.

Given as examples of compounds having a glycidyl ether structure are polyether polyols obtained by adding one or more alkylene oxides to aliphatic higher alcohol such as bisphenol A diglycidyl ether, bisphenol F diglycidyl ether, bisphenol S diglycidyl ether, brominated bisphenol A diglycidyl ether, brominated bisphenol F diglycidyl ether, brominated bisphenol S diglycidyl ether, hydrogenated bisphenol A diglycidyl ether, hydrogenated bisphenol F diglycidyl ether, hydrogenated bisphenol AD diglycidyl ether, an epoxy novolak resin, 1,4-butanediol diglycidyl ether, 1,6-hexanediol diglycidyl ether, glycerol triglycidyl ether, trimethylolpropane triglycidyl ether, polyethylene glycol diglycidyl ether, and polypropylene glycol diglycidyl ether; monoglycidyl ethers of aliphatic higher alcohol; and monoglycidyl ethers of phenol, cresol, butylphenol, or polyether alcohol prepared by adding alkylene oxides to these compounds.

The following commercially available products are desirable as the cationic polymerizable organic compound: Epicoat 801, 828 (manufactured by Yuka Shell Co., Ltd.), PY-306, 0163, DY-022 (manufactured by Ciba Geigy), KRM-2720, EP-4000, EP-4080, EP-4900, ED-505, ED-506 (manufactured by Asahi Denka Kogyo Co., Ltd.), Epolight M-1230, Epolight EHDG-L, Epolight 40E, Epolight 100E, Epolight 200E, Epolight 400E, Epolight 70P, Epolight 200P, Epolight 400P, Epolight 1500NP, Epolight 1600, Epolight 80MF, Epolight 100MF, Epolight 4000, Epolight 3002, Epolight FR-1500 (manufactured by Kyoeisha Chemical Industries Co., Ltd.), and Suntoto ST3000, YD-716, YH-300, PG-202, PG-207, YD-172, YDPN638 (manufactured by Toto Kasei Co., Ltd.).

When incorporating the epoxy compound other than component (A) as an additional cationic polymerizable organic compound in the photo-curable resin composition of the present invention, the proportion of this epoxy compound is usually 0-20% by weight, preferably 2-18% by weight, and more preferably 3-15% by weight. The use of this epoxy compound causes the resulting three-dimensional object to have an improved deform stability and improved mechanical characteristics such as toughness. On the other hand, if the proportion of this epoxy compound is too high, the curability of the resulting resin composition may be decreased, leading to a lower molding effect.

Specific examples of cationic polymerizable organic compounds which can be used as the optional components include oxetanes such as trimethylene oxide, 3,3-dimethyl oxetane, 3,3-dichloromethyl oxetane, 3-ethyl-3-phenoxymethyl oxetane, and bis(3-ethyl-3-methyloxy) butane; oxalans such as tetrahydrofuran, and 2,3-dimethyltetrahydrofuran; cyclic acetals such as trioxan, 1,3-dioxalan, and 1,3,6-trioxan cycloctane; cyclic lactones such as β-propyolactone and ε-caprolactone; thiiranes such as ethylene sulfide, 1,2-propylene sulfide, and thioepychlorohydrin; thiethanes such as 3,3-dimethyl thiethane; vinyl ethers such as ethylene glycol divinyl ether, triethylene glycol divinyl ether, and trimethylolpropane trivinyl ether; ethylenicallyally unsaturated compounds such as vinyl cyclohexane, isobutylene, and polybutadiene; and their derivatives.

The photo-curable resin composition of the present invention may include polyols as the optional component to develop the photo-curability of the cationic polymerizable compounds, and to develop the shape stability (resistance to deformation with time) and material stability of the three-dimensional object prepared by the photo-fabricating process.

Polyols having 3 to 6 hydroxyl groups in one molecule are preferably used. When using polyols having 3 hydroxyl groups or more, the photo-curability and mechanical characteristics are improved. On the other hand, when using polyols having 6 or more hydroxyl groups, there is a tendency for the elongation and toughness of the three-dimensional object to be reduced.

Preferred examples of such polyols include polyether polyols prepared by modifying polyhydric alcohol of a valence greater than 3, such as trimethylolpropane, glycerol, pentaerythritol, sorbitol, sucrose, and the like by a cyclic ether compound such as ethylene oxide, propylene oxide, butylene oxide, tetrahydrofuran, and the like; polycaprolactone polyols prepared by modifying by caprolactone; and polyester polyols. Specific examples of such polyether polyols include EO modified trimethylolpropane, PO modified trimethylolpropane, tetrahydrofuran modified trimethylolpropane, caprolactone modified trimethylolpropane, EO modified glycerol, PO modified glycerol, tetrahydrofuran modified glycerol, caprolactone modified glycerol, EO modified pentaerythritol, PO modified pentaerythritol, tetrahydrofuran modified pentaerythritol, EO modified sorbitol, PO modified sorbitol, EO modified sucrose, PO modified sucrose, and EO modified quodor. Among these, EO modified trimethylolpropane, PO modified trimethylolpropane, caprolactone modified trimethylolpropane, PO modified glycerol, caprolactone modified glycerol, and PO modified sorbitol are preferred. These polyols may be used either individually or in combinations of two or more.

The preferable molecular weight of a polyether polyol is 100 to 2,000, and more preferably 160-1,000. If polyether polyols having too small a molecular weight are used, it is difficult to prepare a three-dimensional object with stable shape and properties. On the other hand, if polyether polyols having too large a molecular weight are used, the viscosity of the resulting resin composition becomes too large, resulting in lowering of the mechanical strength of the three-dimensional object obtained by the photo-fabricating process.

Specific examples of commercially available polyether polyol products include Sunnix TP-400, Sunnix GP-600, Sunnix GP-1000, Sunnix SP-750, Sunnix GP-250, Sunnix GP-400, Sunnix GP-600 (manufactured by Sanyo Chemical Co., Ltd.), TMP-3 Glycol, PNT-4 Glycol, EDA-P-4, EDA-P-8 (manufactured by Nippon Nyukazai Co., Ltd.), G-300, G-400, G-700, T-400, EDP-450, SP-600, SC-800 (manufactured by Asahi Denka Kogyo Co., Ltd.), TONE0301, TONE0305, TONE0310 (manufactured by Union Carbide Corporation.) and Plakcel 303, Plakcel 305, Plakcel 308 (manufactured by Daicel Chemical Industries Ltd.).

When the polyols are incorporated in the photo-curable resin composition of the present invention, the proportion of polyol is usually 0-10% by weight and preferably 1-5% by weight. If the proportion of polyol is too large, the mechanical strength of the three-dimensional object obtained by the photo-fabricating process tends to be adversely affected by humidity and moisture.

Other optional components include photosensitizers (polymerization promoters) of amine compounds such as triethanolamine, methyl diethanolamine, triethylamine, diethylamine; photosensitizers including thioxantone or its derivatives, anthraquinone or its derivatives, anthracene or its derivatives, perillene and its derivatives, benzophenone, benzoin isopropylether, and the like; and reactive diluents such as vinyl ether, vinyl sulfide, vinyl urethane, urethane acrylate, or vinyl urea; polymers or oligomers, such as epoxy resin, polyamide, polyamideimide, polyurethane, polybutadiene, polychloroprene, polyether, polyester, styrene-butadiene-styrene block copolymer, petroleum resin, xylene resin, ketone resin, cellulose resin, fluorine-containing oligomer, silicon-containing oligomer, and polysulfide oligomer; polymerization inhibitors such as phenothiazine or 2,6-di-t-butyl-4-methyl phenol, polymerization initiation adjuvants, leveling agents, wettability improvers, surfactants, plasticizers, UV stablizers, UV absorbers, silane coupling agents, inorganic fillers, resin particles, pigments, dyes and the like.

The photo-curable resin composition of the present invention can be manufactured by homogeneously blending the above-mentioned components (A) to (E) and the optional components, as required. It is desirable for the photo-curable resin composition of the present invention to possess a viscosity at 25°C preferably in the range of 0.5-20 Pa.s (500-20,000 cps), or more preferably in the range of 1-10 Pa.s (1,000-10,000 cps).

If the viscosity at 25°C of the resulting photo-curable resin composition is less than 0.5 Pa.s (500 cps), the precipitation rate of the silica particles is accelerated and the distribution of silica particles in the fabricated product is nonuniform. It is therefore difficult to prepare a mold with sufficient high mechanical strength to be injection-molded. In contrast, if the viscosity at 25°C of the photo-curable resin composition exceeds 20 Pa.s (20,000 cps), cured products with a smooth surface can be obtained only with difficulty and a mold with high dimensional accuracy cannot be prepared.

Manufacture of three-dimensional objects

The photo-curable resin composition of the present invention prepared in this manner is suitable as a photo-curable material used in photo-fabricating processes. Specifically, a three-dimensional object with a desired shape consisting of integrally laminated cured resin layers can be obtained by repeating the step of forming a cured layer from the photo-curable resin composition of the present invention by selective irradiation using visible light, ultraviolet light, or infrared light.

Illustrating the process for manufacturing such a three-dimensional object more specifically, the photo-curable resin composition is supplied to a suitable supporting stage to form a thin layer (1) of the photo-curable resin composition, this thin layer (1) is selectively irradiated with light to produce a cured solid resin layer (1'), the photo-curable

resin composition is supplied over this cured resin layer (1') to form a second thin layer (2), and this thin layer (2) is selectively irradiated with light to produce a new cured resin layer (2') integrally laminated on the first resin layer. This step is repeated for a prescribed number of times, with or without changing the pattern subjected to light irradiation, to produce a three-dimensional object consisting of a multiple number of cured resin layers (n) which are integrally laminated.

Various means may be used to selectively irradiate the photo-curable resin composition with light. Such light irradiation means include, for example, (1) a means for irradiating the composition while scanning with a laser beam or with a light converged by a lens, mirror, or the like, (2) a means for irradiating the composition with non-convergent light through a mask provided with a fixed pattern through which light is transmitted, (3) and a means for irradiating the composition with light via a number of optical fibers bundled in a light conductive member corresponding to a fixed pattern. In the means using a mask, it is optional to use a mask which electrooptically produces a mask image consisting of a light transmitting area and non-light-transmitting area according to a prescribed pattern by the same theory as that of the liquid crystal display apparatus. Among these means of light irradiation, the means for selectively irradiating the composition by scanning with laser light is preferred for fabricating a three-dimensional object possessing minute parts or requiring high dimensional accuracy.

The three-dimensional object fabricated in this manner is processed to remove unreacted photo-curable resin composition remaining on the surface, and washed with a solvent for the uncured resin, as required. As solvents, alcohols such as isopropyl alcohol and ethyl alcohol, esters such as ethyl acetate, ketones such as acetone and methylethyl ketone, terpenes, and aliphatic organic solvents represented by glycol ester, or a low viscosity liquid thermosetting resin or photo-curable resin, can be used as the washing agent in this washing step.

In this instance, it is desirable that the product be subjected to a post-curing treatment, which may be a treatment with heat or light irradiation, after washing, depending on the type of curable resin used as the washing agent. This post-curing treatment is effective not only for curing any uncured resin on the surface of the laminated body, but also for curing any uncured resin composition inside the laminated body. Thus, the post-curing treatment is also effective in the case where the fabricated three-dimensional object is washed with an organic solvent.

Also, it is desirable to cover the surface of the three-dimensional object after washing with a heat-curable or photo-curable hard coating agent to improve the strength and heat resistance of the surface. As such a hard coating agent, an organic coating agent such as acryl resin, epoxy resin, silicone resin, or the like, or various inorganic coating agents can be used. These hard coating agents may be used individually or in combinations of two or more.

Because the three-dimensional object obtained according to this invention has high dimensional accuracy, a high heat distortion temperature over 100°C, and the mechanical strength and excellent heat resistance required for a mold to be used under conditions of high pressure and high temperature, this object is suitable as a resin-based mold which is used for various molding methods, such as an injection molding, press molding, vacuum molding, high-pressure molding, foaming mold, and pulp molding.

## EXAMPLES

The present invention will be explained in more detail by way of examples, which are not intended to be limiting of the present invention.

In this examples, microphotographs of spherical silica particles used as the component (E) and glass beads were taken using a scanning electron microscope (manufactured by JEOL Ltd.). The microphotographs were analyzed by an image analyzer to measure the projection area ($S_p$) and the peripheral length (c) of the projected image on the photograph. The average projection area ($S_p$) and peripheral length (c) of 100 particles selected from a multitude of particles were each measured to calculate the average sphericity of the particles or glass beads.

### Examples 1 to 3

The components (A), (B), (C), (D), and the optional components according to the formulations shown in Table 1 were placed in a vessel with a stirrer, and the mixture was agitated at 50°C for 2 hours to prepare a homogeneous resin solution. The resin solution was then mixed with spherical silica particles (average sphericity: 0.97, average particle diameter: 10 μm), after which the mixture was placed in a vessel with a high-speed stirrer and agitated (rotating speed: 3000 rpm) at room temperature for 10 minutes. The compositions (1) to (3) in which the component (E) was homogeneously dispersed were thus obtained as the photo-curable resin composition of the present invention. All the compositions (1)-(3) were opaque, homogeneous, and viscous solutions.

### Comparative Example 1

The components (A), (B), (C), (D), and the optional components according to the formulations shown in Table

1 were placed in a vessel with a stirrer, and the mixture was agitated at 50°C for 2 hours to prepare a homogeneous resin solution. The resin solution was then mixed with spherical silica particles (average sphericity: 0.97, average particle diameter: 10 μm), after which the mixture was placed in a vessel with a high-speed stirrer and agitated (rotating speed: 3,000 rpm) at room temperature for 10 minutes. The composition (4) in which the component (E) was homogeneously dispersed was thus obtained as a comparative photo-curable resin composition. The composition (4) prepared in this Comparative Example 1 was an opaque, homogeneous, and viscous solution. This Comparative Example 1 is an example in which the resulting cured product from the resin composition has a heat distortion temperature of under 100°C.

Comparative Example 2

The components (A), (B), (C), (D), and the optional components according to the formulations shown in Table 1 were placed in a vessel with a stirrer, and the mixture was agitated at 50°C for 2 hours to prepare a homogeneous resin solution. The resin solution was then mixed with undefined silica particles (average sphericity: 0.85, average particle diameter: 14 μm), after which the mixture was placed in a vessel with a high-speed stirrer and agitated (rotating speed: 3,000 rpm) at room temperature for 10 minutes. The composition (5) in which the undefined particles were homogeneously dispersed was thus obtained as a comparative photo-curable resin composition. The composition (5) prepared in this Comparative Example 2 was an opaque, homogeneous, and viscous solution. This Comparative Example 2 is an example in which undefined silica particles are used for the component (E).

Comparative Example 3

The components (A), (B), (C), (D), and the optional components according to the formulations shown in Table 1 were placed in a vessel with a stirrer, and the mixture was agitated at 50°C for 2 hours to prepare a homogeneous resin solution. The resin solution was then mixed with glass beads (average sphericity: 0.97, average particle diameter: 17 μm) in the amount shown in Table 1, after which the mixture was placed in a vessel with a high-speed stirrer and agitated (rotating speed: 3,000 rpm) at room temperature for 10 minutes. The composition (6) in which the glass beads were homogeneously dispersed was thus obtained as a comparative photo-curable resin composition. The composition (6) prepared in this Comparative Example 3 was an opaque, homogeneous, and viscous solution. This Comparative Example 3 is an example in which glass beads are used for the component (E).

Comparative Example 4

The components (A), (B), and the optional components according to the formulations shown in Table 1 were placed in a vessel with a stirrer, and the mixture was agitated at 50°C for 2 hours to prepare a homogeneous resin solution. The resin solution was then mixed with the component (E) in the amount shown in Table 1, after which the mixture was placed in a vessel with a high-speed stirrer and agitated (rotating speed: 3,000 rpm) at room temperature for 10 minutes. The composition (7) in which the component (E) was homogeneously dispersed was thus obtained as a comparative photo-curable resin composition. The composition (7) prepared in this Comparative Example 4 was an opaque, homogeneous, and viscous solution. This Comparative Example 4 is an example in which the components (C) and (D) are not formulated.

TABLE 1

(% by weight)

| | Example | | | Comparative Example | | | |
|---|---|---|---|---|---|---|---|
| | 1 | 2 | 3 | 1 | 2 | 3 | 4 |
| Composition | 1 | 2 | 3 | 4 | 5 | 6 | 7 |
| Component (A)<br>3,4-Epoxycyclohexylmethyl-3,4-epoxycyclohexane carboxylate *(a) | 23 | 23 | 20 | 42 | 20 | 23 | 30 |
| Component (B)<br>Bis[4-(diphenylsulfonio)phenyl]sulfide bishexafluooantimonate | 1 | 1 | 1 | 1 | 1 | 1 | 1 |
| Component (C)<br>Trimethylolpropane triacrylate *(b)<br>Dipentaerythritol hexacrylate *(c) | 4<br>2 | 4<br>2 | 6<br>- | 7<br>4 | 3<br>2 | 4<br>2 | -<br>- |
| Component (D)<br>1-Hydroxycyclohexyl phenyl ketone *(d) | 1 | 1 | 1 | 1 | 1 | 1 | - |
| Component (E)<br>Spherical silica particles (average sphericity: 0.97) *(e) | 60 | 60 | 60 | 30 | - | - | 60 |

| | Example | | | Comparative Example | | | |
|---|---|---|---|---|---|---|---|
| | 1 | 2 | 3 | 1 | 2 | 3 | 4 |
| Composition | 1 | 2 | 3 | 4 | 5 | 6 | 7 |
| Optional Components | | | | | | | |
| Butane diol glycidyl ether *(f) | 9 | 8.5 | 9 | 15 | 8 | 9 | 9 |
| Caprolactane-modified triol *(g) | - | - | 3 | - | - | - | - |
| Epoxy-based silane coupling agent *(h) | - | 0.5 | - | - | - | - | - |
| Amorphous silica particles (average sphericity: 0.85) *(i) | - | - | - | - | 65 | - | - |
| Glass beads (average sphericity: 0.97) *(j) | - | - | - | - | - | 60 | - |

The name of the commercially available products denoted by (a)-(j) in the Table 1 are as follows:

(a): [UVR 6110] (manufactured by Union Carbide Corporation)
(b): [Viscoat 295] (manufactured by Osaka Organic Chemical Industry Ltd.)
(c): [KAYARAD DPHA] (manufactured by Nippon Kayaku Co., Ltd.)
(d): [Irgacure 184] (manufactured by Ciba Geigy)
(e): [Sunsfair NP-100] (manufactured by Doukai Kagaku Kogyo Ltd.)
(f): [Araldite DY-022] (manufactured by Ciba Geigy)
(g): [TONE-0301] (manufactured by Union Carbide Corporation)
(h): [S-530] (manufactured by Chisso Corporation)
(i): [RD-8X] (manufactured by Tatsumori Kogyo Co., Ltd.)
(j): [GB045ZC] (manufactured by Toshiba Valotini Co., Ltd.)

Evaluation of photo-curable resin compositions

The optimum scanning speeds of the compositions (1)-(3) prepared in Examples 1-3 and the compositions (4)-(7) prepared in Comparative Examples 1-4 were measured to evaluate the photo-curability of the composition. Also, a cured product was produced from the composition and the heat distortion temperature of the cured product was measured. The results are shown in Table 2.

Photo-curability

Using an photo-fabricating apparatus (Solid Creator JSC-2000, manufactured by Sony Corporation) equipped with a light source for applying an Ar ion laser beam (wave length of 351 nm and 365 nm), the above-mentioned composition was selectively irradiated by the laser beam under the condition of laser power of 100 mW measured on the irradiated surface (liquid level) while scanning. The scanning speed (optimum scanning speed) was measured when a cured resin film with a thickness of 0.3 mm was produced. The photo-curability was evaluated by the following standards:

AAA: Optimum scanning speed more than 120 cm/second
BBB: Optimum scanning speed in the range from 100 to 120 cm/second
CCC: Optimum scanning speed in the range from 10 to 100 cm/second
DDD: No cured film produced

Heat distortion temperature

Using the photo-fabricatiing apparatus (Solid Creator JSC-2000, manufactured by Sony Corporation), a part (length: 120mm, width: 11 mm, thickness: 4 mm) of a fabricating product was prepared under the following conditions.

(A) Laser beam intensity on the liquid level: 100 mW
(B) Scanning speed: optimum scanning speed when the cured depth reaches 0.3 mm
(C) Thickness of the cured resin layer: 0.2 mm
(D) Number of laminations: 20

After removing the resin composition adhering to the surface of the fabricated product, the fabricated product was washed with a solvent. The fabricated product was then annealed at 160°C for 2 hours in a thermal oven to prepare a test specimen for the measurement of heat distortion temperature.
The heat distortion temperature was measured according to JIS K7207 A.

Preparation of resin-based molds

Cavity molds and core molds were prepared from the compositions (1) to (5) obtained in the Examples 1-3 and the Comparative Examples 1 an 2 using an photo-fabricating apparatus "Solid Creator JSC-2000(tm)" (manufactured by Sony Corporation) under the following conditions.

Laser beam intensity on the liquid surface: 100 mW
Scanning rate: the optimum scanning speed when the cured depth reaches 0.3 mm
Thickness of cured resin layer: 0.2 mm
Number of lamination for cavity mold: 306
Number of lamination for core mold: 220

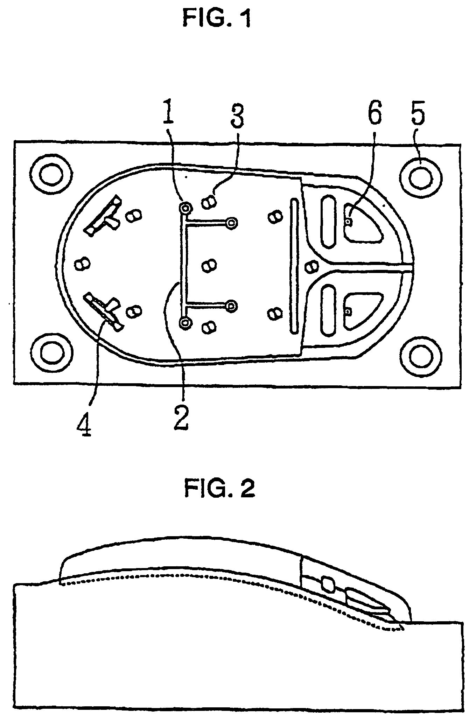

Figure 1 is a plan view and Figure 2 a sideview of the cavity mold. In Figure 1, 1 denotes a pin form, 2 a rib, 3 a pin form, 4 a nail, 5 a securing screw hole, 6 a pin form.

After treatment

After wiping the molded cavity mold and core mold to remove the resin composition adhering to their surfaces and washing with a solvent, they were annealed at 160°C for 2 hours in a thermal oven.

Evaluation of resin-made mold (injection mold)

Using the resin-made cavity molds and core molds prepared in this manner, a molding material consisting of polycarbonate resin (Yupiron S-2000, manufactured by Mitsubishi Gas Chemical Co., Inc.) was injection-molded under a mold clamping force of 75 tons, a cylinder temperature of 300°C, a mold temperature of 65°C, an injection pressure of 200 kg/cm$^2$, a holding pressure of 360 kg/cm$^2$ in the first stage (holding time: 4 seconds), and a holding pressure of 230 kg/cm$^2$ in the second stage (holding time: 6 seconds) to prepare a molded product. The dimensional accuracy of the molded product and repetition durability of the resin-made mold were evaluated by the following standards.

Dimensional accuracy of the molded product

Good: When the dimensional deviation was less than 0.5% of the target molded article.
Bad: When the dimensional deviation was greater than 0.5% of the target molded article.

Repetition durability

The number of times which the resin-made mold could mold the articles without being broken when used continuously for injection molding.

TABLE 2

| | Example | | | Comparative Example | | | |
|---|---|---|---|---|---|---|---|
| | 1 | 2 | 3 | 1 | 2 | 3 | 4 |
| Composition | 1 | 2 | 3 | 4 | 5 | 6 | 7 |
| Photocurability | BBB | BBB | AAA | BBB | BBB | DDD | CCC |
| Heat distortion temperature (°C) | 150 | 165 | 110 | 85 | 160 | - | - |
| Dimensional Accuracy of injection molded article | Good | Good | Good | Bad | Bad | - | - |
| Repetition durability (times) | >100 | >100 | >100 | 5 | 35 | - | - |

As is clear from Tables 1 and 2, all compositions (1)-(3) prepared in the Examples 1-3 had a suitable photo-curability as the photo-curable material used in the photo-fabricating process. Also, the cured products prepared from the compositions had a high heat distortion temperature of over 100°C, which fact revealed that the compositions had sufficient heat resistance. It is understood that the resin-made molds fabricated from the compositions (1)-(3) used as the photo-curable material can provide molded products with high dimensional accuracy and that the resin-made molds have high repetition durability.

In contrast, the cured product from the composition (4) prepared in the Comparative Example 1 has a heat distortion temperature of less than 100°C. Fabricated products with a high dimensional accuracy could not be obtained using resin-based molds prepared from such compositions. The resulting resin-based molds have a low repetition durability.

The cured products produced from the composition (5) prepared in the Comparative Example 2 have a suitable photo-curability as the photo-curable material used in the photo-fabricating process. The cured product has high heat resistance as shown by a high heat distortion temperature of 160°C. However, because undefined silica particles are used instead of the spherical silica particles as the component (E), molded products with high dimensional accuracy could not be obtained using resin-made molds fabricateed using the composition. The resin-made molds have a low repetition durability.

The composition (6) prepared in the Comparative Example 3 cannot be cured by irradiation with a laser beam because spherical glass beads are used as the component (E) instead of the spherical silica particles.

The composition (7) prepared in the Comparative Example 4 has a low cure rate, because of the absence of the components (C) and (D). A cured product with sufficient mechanical strength cannot be obtained from the composition.

The photo-curable resin composition of the present invention can produce cured products exhibiting excellent mechanical strength and heat resistance. The composition can therefore be suitably used as the photo-curable material for photo-fabricating methods.

In addition, the process for manufacturing a resin-based mold of the present invention can easily produce a resin-based mold which exhibits excellent molding dimensional precision and repetition durability as shown by the fact that the resin-based mold is neither deformed or damaged after repeating the molding treatment over 100 times.

**Claims**

**1.** A photo-curable resin composition comprising,

(A) a compound having a cyclohexene oxide structure;
(B) a cationic photo-initiator;
(C) a ethylenically unsaturated polymer;
(D) a radical photo-initiator; and
(E) spherical silica particles;

wherein upon curing, the resin composition has a heat distortion temperature of 100°C or higher.

**2.** The resin composition according to claim 1, wherein component (A) has a molecular weight of about 100 to about 400.

**3.** The resin composition according to any one of claims 1-2, wherein component (A) contains an average of about two epoxy groups.

**4.** The resin composition according to any one of claims 1-3, wherein component (A) is present in an amount of 5-60% by weight relative to components (A)-(E).

**5.** The resin composition according to any one of claims 1-4, wherein component (B) is present in an amount of 0.1-10 % by weight, relative to components (A)-(E).

**6.** The resin composition according to any one of claims 1-5, wherein the ethylenically unsaturated monomer of component (C) has a molecular weight of about 80-2000.

**7.** The resin composition according to any one of claims 1-6, wherein the ethylenically unsaturated monomer of component (C) comprises at least one monomer having 3 or more ethylenically unsaturated groups.

**8.** The resin composition according to any one of claims 1-7, wherein the component (C) consists of more than 80% of a polyfunctional monomer, having at least 3 functional groups.

**9.** The resin composition according to any one of claims 1-8, wherein component (C) is present in 1-30 % by weight, relative to components (A)-(E).

**10.** The resin composition according to any one of claims 1-9, wherein component (D) is present in 0.01-8 & by weight, relative to components (A)-(E).

**11.** The resin composition according to any one of claims 1-10, wherein component (E) is present in 40-80 % by weight, relative to components (A)-(E).

**12.** The resin composition according to any one of claims 1-11, wherein the spherical silica particles have a sphericity of at least 0.9, and further, wherein the sphericity is defined as by the following formula,

$$\text{Sphericity} = \frac{\sqrt{4\pi S_p}}{C} = \frac{d_{pa}}{d_{pc}}$$

wherein $S_p$ is a projection area, c is the peripheral length of the projected image, $d_{pa}$ is the diameter of a circle having the same area as that of the projection area, and $d_{pc}$ is the diameter of a circle having the same peripheral length as the projected image of the particle.

**13.** The resin composition according to any one of claims 1-12, wherein the silica particles have a sphericity of at least 0.95.

**14.** The resin composition according to any one of claims 1-13, wherein the silica particles have an average particle diameter of 2-30 μm.

**15.** The resin composition according to any one of claims 1-14, wherein the silica particles are surface treated with a silane coupling agent.

**16.** The resin composition according to any one of claims 1-15, wherein the resin composition comprises as additional components at least one component from the group consisting of: cationic polymerizable compounds, polyols having 3 to 6 hydroxyl groups and a molecular weight of 100-2000, photo-sensitizers, reactive diluents, polymers or oligomers, polymerization inhibitors, leveling agents, surfactants, stabilisers, pigments, dyes, resin particles, or inorganic fillers.

**17.** The resin composition according to any one of claims 1-16, wherein the resin composition has a viscos ity at 25°C of 0.5-20 Pa.s (500-20.000 cps).

**18.** A process for preparing a resin-based mold comprising a plurality of integrally laminated layers of cured resin by repeating the step of forming a cured resin layer by selective irradiation of the photo-curable resin composition defined in any one of claims 1-17, with light.

**19.** The process according to claim 18, wherein the uncured resin is removed from the resin based mold after the forming step, and the resin based mold is subjected to a post-curing-treatment in order to more fully cure the resin.

**20.** Resin based mold formed by a process according to any oneof claims 18-19, wherein a plurality of integrally laminated layers of cured resin are obtained by repeating the step of forming a cured resin layer by selective irradiation of the photo-curable resin composition with light, wherein said resin composition comprises:

(A) a compoundhaving a cyclohexene oxide structure;
(B) a cationic photo-initiator;
(C) a ethylenically unsaturated polymer;
(D) a radical photo-initiator; and
(E) spherical silica particles; and

wherein upon curing, the resin composition has a heat distortion temperature of 100°C or higher.

**Patentansprüche**

**1.** Photohärtbare Harzzusammensetzung, umfassend

(A) eine Verbindung mit einer Cyclohexenoxidstruktur,
(B) einen kationischen Photoinitiator,
(C) ein ethylenisch ungesättigtes Polymer,
(D) einen radikalischen Photoinitiator und
(E) kugelförmige Silicateilchen,

wobei die Harzzusammensetzung nach Härten eine Formbeständigkeitstemperatur von 100°C oder höher aufweist.

**2.** Harzzusammensetzung nach Anspruch 1, wobei die Komponente (A) ein Molekulargewicht von etwa 100 bis etwa 400 aufweist.

**3.** Harzzusammensetzung nach einem der Ansprüche 1-2, wobei die Komponente (A) einen Durchschnitt von etwa zwei Epoxygruppen enthält.

**4.** Harzzusammensetzung nach einem der Ansprüche 1-3, wobei die Komponente (A) in einer Menge von 5-60 Gew.-% relativ zu den Komponenten (A)-(E) vorliegt.

**5.** Harzzusammensetzung gemäß einem der Ansprüche 1-4, wobei die Komponente (B) in einer Menge von 0,1-10 Gew.-%, relativ zu den Komponenten (A)-(E), vorliegt.

**6.** Hatzzusammensetzung gemäß einem der Ansprüche 1-5, wobei das ethyle nisch ungesättigte Monomer der Komponente (C) ein Molekulargewicht von etwa 80-2000 aufweist.

**7.** Harzzusammensetzung gemäß einem der Ansprüche 1-6, wobei das ethylenisch ungesättigte Monomer der Komponente (C) mindestens ein Monomer mit 3 oder mehr ethylenisch ungesättigten Gruppen umfaßt.

**8.** Harzzusammensetzung gemäß einem der Ansprüche 1-7, wobei die Komponente (C) aus mehr als 80% eines polyfunktionalen Monomers mit mindestens 3 funktionalen Gruppen besteht.

**9.** Harzzusammensetzung gemäß einem der Ansprüche 1-8, wobei die Komponente (C) in 1-30 Gew.-%, relativ zu den Komponenten (A)-(E), vorliegt.

**10.** Harzzusammensetzung gemäß einem der Ansprüche 1-9, wobei die Komponente (D) in 0,01-8 Gew.-%, relativ zu den Komponenten (A)-(E), vorliegt.

**11.** Harzzusammensetzung gemäß einem der Ansprüche 1-10, wobei die Komponente (E) in 40-80 Gew.-%, relativ zu den Komponenten (A)-(E), vorliegt.

**12.** Harzzusammensetzung gemäß einem der Ansprüche 1-11, wobei die kugelförmigen Silicateilchen eine Kugelförmigkeit von mindestens 0,9 und weiter aufweisen, wobei die Kugelförmigkeit durch die folgende Formel definiert ist

$$\text{Kugelförmigkeit} = \frac{\sqrt{4\Pi S_p}}{C} = \frac{d_{pa}}{d_{pc}}$$

wobei $S_p$ eine Projektionsfläche ist, c die Umfangslänge des projizierten Bilds ist, $d_{pa}$ der Durchmesser eines Kreises mit der gleichen Fläche wie die der Projektionsfläche ist, und $d_{pc}$ der Durchmesser eines Kreises mit der gleichen Umfangslänge wie das projizierte Bild des Teilchens ist.

**13.** Harzzusammensetzung gemäß einem der Ansprüche 1-12, wobei die Silicateilchen eine Kugelförmigkeit von mindestens 0,95 aufweisen.

**14.** Harzzusammensetzung gemäß einem der Ansprüche 1-13, wobei die Silicateilchen einen durchschnittlichen Teilchendurchmesser von 2-30 μm aufweisen.

**15.** Harzzusammensetzung gemäß einem der Ansprüche 1-14, wobei die Silicateilchen mit einem Silankupplungsmittel oberflächenbehandelt sind.

**16.** Harzzusammensetzung gemäß einem der Ansprüche 1-15, wobei die Harzzusammensetzung als zusätzliche Komponenten mindestens eine Komponente aus der Gruppe, bestehend aus: kationischen polymerisierbaren Verbindungen, Polyolen mit 3 bis 6 Hydroxylgruppen und einem Molekulargewicht von 100-2000, photoempfindlichen Mitteln, reaktiven Verdünnungsmitteln, Polymeren oder Oligomeren, Polymerisationsinhibitoren, Ausgleichsmitteln, grenzflächenaktiven Mitteln, Stabilisatoren, Pigmenten, Farbstoffen, Harzteilchen oder anorganischen Füllstoffen, umfasst.

**17.** Harzzusammensetzung gemäß einem der Ansprüche 1-16, wobei die Harzzusammensetzung eine Viskosität bei

25°C von 0,5-20 Pa·s (500-20.000 cps) aufweist.

18. Verfahren zur Herstellung einer Form auf Harzbasis, umfassend eine Vielzahl von integral laminierten Schichten von gehärtetem Harz durch Wiederholen des Schritts des Bildens einer gehärteten Harzschicht durch selektive Bestrahlung der photohärtbaren Harzzusammensetzung, wie in einem der Ansprüche 1-17 definiert, mit Licht.

19. Verfahren nach Anspruch 18, wobei das ungehärtete Harz von der Form auf Harzbasis nach dem Bildungsschritt entfernt wird und die Form auf Harzbasis einer Nachhärtungsbehandlung unterworfen wird, um das Harz vollständiger zu härten.

20. Form auf Harzbasis, gebildet durch ein Verfahren gemäß einem der Ansprüche 18-19, wobei eine Vielzahl von integral laminierten Schichten von gehärtetem Harz durch Wiederholen des Schritts des Bildens einer gehärteten Harzschicht durch selektive Bestrahlung der photohärtbaren Harzzusammensetzung mit Licht erhalten wird, wobei die Harzzusammensetzung umfaßt:

(A) eine Verbindung mit einer Cyclohexenoxidstruktur,
(B) einen kationischen Photoinitiator,
(C) ein ethylenisch ungesättigtes Polymer,
(D) einen radikalischen Photoinitiator und
(E) kugelförmige Silicateilchen, und

wobei die Harzzusammensetzung nach Härten eine Formbeständigkeitstemperatur von 100°C oder höher aufweist.

## Revendications

1. Composition à base de résine photodurcissable comprenant,

(A) un composant ayant une structure oxyde de cyclohexène ;
(B) un photoinitiateur cationique ;
(C) un polymère éthyléniquement insaturé ;
(D) un photoinitiateur radicalaire ; et
(E) des particules de silice sphériques ;

dans laquelle, sous l'effet du traitement thermique, la composition à base de résine présente une température de distorsion thermique de 100 °C ou plus.

2. Composition à base de résine selon la revendication 1, dans laquelle le composant (A) a un poids moléculaire compris entre 100 et 400 environ.

3. Composition à base de résine selon l'une quelconque des revendications 1 à 2, dans laquelle composition le composant (A) comprend une moyenne d'environ deux groupes époxy.

4. Composition à base de résine selon l'une quelconque des revendications 1 à 3, dans laquelle composition le composant (A) est présent dans une quantité comprise entre 5 et 60 % en poids, en fonction des composants (A) à (E).

5. Composition à base de résine selon l'une quelconque des revendications 1 à 4, dans laquelle composition le composant (B) est présent dans une quantité comprise entre 0,1 et 10 % en poids, en fonction des composants (A) à (E).

6. Composition à base de résine selon l'une quelconque des revendications 1 à 5, dans laquelle composition le monomère éthyléniquement insaturé du composant (C) a un poids moléculaire compris entre 80 et 2000 environ.

7. Composition à base de résine selon l'une quelconque des revendications 1 à 6, dans laquelle composition le monomère éthyléniquement insaturé du composant (C) comprend au moins un monomère ayant 3 groupes éthyléniquement insaturés ou plus.

**8.** Composition à base de résine selon l' une quelconque des revendications 1 à 7, dans laquelle composition le composant (C) comprend plus de 80 % d'un monomère polyfonctionnel, ayant au moins 3 groupes fonctionnels.

**9.** Composition à base de résine selon l'une quelconque des revendications 1 à 8, dans laquelle composition le composant (C) est présent dans 1 à 30 % en poids, en fonction des composants (A) à (E).

**10.** Composition à base de résine selon l'une quelconque des revendications 1 à 9, dans laquelle composition le composant (D) est présent dans 0,01 à 8 % en poids, en fonction des composants (A) à (E).

**11.** Composition à base de résine selon l'une quelconque des revendications 1 à 10, dans laquelle composition le composant (E) est présent dans 40 à 80 % en poids, en fonction des composants (A) à (E).

**12.** Composition à base de résine selon l'une quelconque des revendications 1 à 11, dans laquelle composition les particules de silice sphériques ont une sphéricité d'au moins 0,9, et dans laquelle composition la sphéricité est définie par la formule suivante,

$$\text{Sphéricité} = \frac{\sqrt{4\pi S_p}}{C} - \frac{d_{pa}}{d_{pc}}$$

dans laquelle $S_p$ est une surface de projection, c'est la longueur périphérique de l'image projetée, $d_{pa}$ est le diamètre d'un cercle ayant la même surface que celle de la surface projetée et $d_{pc}$ est le diamètre d'un cercle ayant la même longueur périphérique que l'image projetée de la particule.

**13.** Composition à base de résine selon l'une quelconque des revendications 1 à 12, dans laquelle composition les particules de silice ont une sphéricité d'au moins 0,95.

**14.** Composition à base de résine selon l'une quelconque des revendications 1 à 13, dans laquelle composition les particules de silice ont un diamètre de particules moyen compris entre 2 et 30 µm.

**15.** Composition à base de résine selon l'une quelconque des revendications 1 à 14, dans laquelle composition les particules de silice sont traitées en surface à l'aide d'un agent de couplage au silane.

**16.** Composition à base de résine selon l'une quelconque des revendications 1 à 15, dans laquelle la composition à base de résine comprend, en tant que composants supplémentaires, au moins un composant du groupe comprenant : des composés cationiques polymérisables, des polyols ayant de 3 à 6 groupes hydroxyles et un poids moléculaire compris entre 100 et 2000, des photosensibilisateurs, des diluants réactifs, des polymères ou des oligomères, des inhibiteurs de polymérisation, des agents fluidifiants, des agents de surface, des stabilisateurs, des pigments, des colorants, des particules de résine ou des charges inorganiques.

**17.** Composition à base de résine selon l'une quelconque des revendications 1 à 16, dans laquelle la composition à base de résine présente une viscosité de 0,5 à 20 Pa-s (500 à 20 000 cps) à 25 °C.

**18.** Procédé permettant de préparer un moule à base de résine comprenant une pluralité de couches intégralement laminées de résine durcie en répélant l'étape consistant à former une couche de résine durcie par irradiation sélective de la composition à base de résine photodurcissable, définie dans l'une quelconque des revendications 1 à 17, à la lumière.

**19.** Procédé selon la revendication 18, dans lequel la résine non durcie est éliminée du moule à base de résine après l'étape de formation, et le moule à base de résine est soumis à un traitement post-durcissement afin de durcir la résine de façon complète.

**20.** Moule à base de résine, formé au moyen d'un procédé selon l'une quelconque des revendications 18 à 19, dans lequel moule une pluralité de couches intégralement laminées de résine durcic sont obtenues en répétant les étapes consistant à former une couche de résine durcie par irradiation sélective de la composition à base de résine photodurcissable à la lumière, dans lequel moule ladite composition à base de résine comprend :

(A) un composé ayant une structure cyclohexène oxyde

(B) un photoinitiateur cationique ;
(C) un polymère éthyléniquement insaturé ;
(D) un photoinitiateur radicalaire ; et
(E) des particules de silice sphériques ; et

dans laquelle, sous l'effet du traitement thermique, la composition à base de résine présente une temperature de distorsion thermique de 100 °C ou plus.

FIG. 1

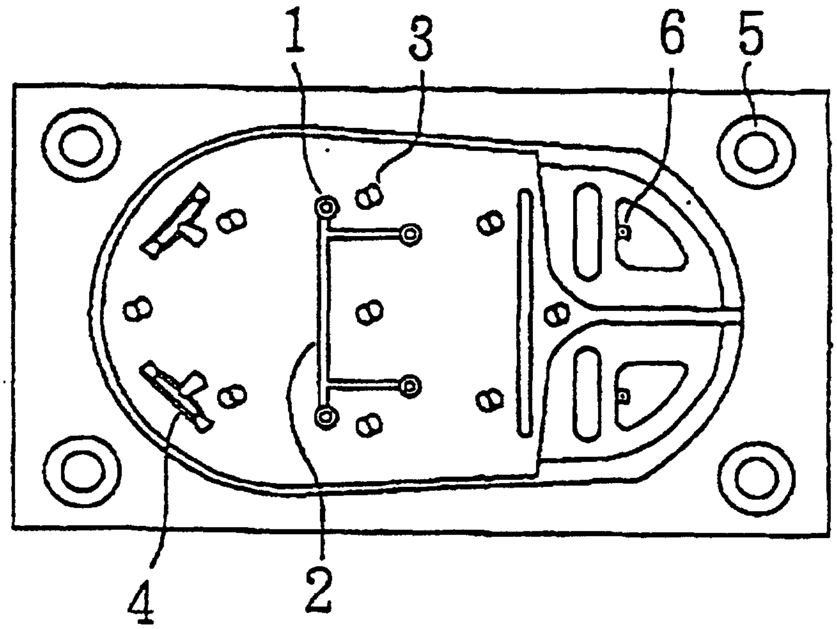


FIG. 2